# FASCICULE DE BREVET EUROPEEN

(11) **EP 4 462 987 B1**
(45) Date de publication et mention de la délivrance du brevet: **11.03.2026**
(21) Numéro de dépôt: 24305709.8
(22) Date de dépôt: 03.05.2024
(51) Int. Cl.: H10N 70/20

(54) **CELLULE MEMOIRE RESISTIVE ET SON PROCÉDÉ DE FABRICATION**
RESISTIVE SPEICHERZELLE UND DEREN HERSTELLUNGSVERFAHREN
RESISTIVE MEMORY CELL AND FABRICATION METHOD THEREOF

(30) Priorité: 09.05.2023 FR 2304573
(43) Date de publication de la demande: 13.11.2024
(73) Titulaire: Commissariat à l'Energie Atomique et aux Energies Alternatives, 75015 Paris (FR); Centre National de la Recherche Scientifique, 75016 Paris (FR); Université Grenoble Alpes, 38400 Saint-Martin-d'Hères (FR); Institut Polytechnique de Grenoble, 38000 Grenoble (FR)
(72) Inventeur: LABORIE, Leo, 38054 Grenoble Cedex 09 (FR); HIDA, Rachid, 38054 Grenoble Cedex 09 (FR); JALAGUIER, Eric, 38054 Grenoble Cedex 09 (FR); LEFEVRE, Gauthier, 38054 Grenoble Cedex 09 (FR); NAVARRO, Gabriele, 38054 Grenoble Cedex 09 (FR); VEYRET, Killian, 38054 Grenoble Cedex 09 (FR); ZUCCHI, Xavier, 38054 Grenoble Cedex 09 (FR); BON, Romain, 38054 Grenoble Cedex 09 (FR)
(74) Mandataire: Cabinet Camus Lebkiri

(56) Documents cités:
- CN-A- 102 130 296
- US-A1- 2013 270 509
- TRANCHANT J ET AL: "Mott Memory Devices Based on the Mott Insulator (V1-xCrx)2O3", 2018 IEEE INTERNATIONAL MEMORY WORKSHOP, 13-16 MAI 2018, KYOTO, JAPON, 2018, XP033362669, DOI: 10.1109/IMW.2018.8388841
- WANG D ET AL: "Interface engineering for a VOx based memristor with an ultralow switching voltage and logic functions", JOURNAL OF ALLOYS AND COMPOUNDS, vol. 921, 166226, 8 July 2022 (2022-07-08), XP087135353, DOI: 10.1016/J.JALLCOM.2022.166226
- WON S ET AL: "Electric Field-Triggered Metal-Insulator Transition Resistive Switching of Bilayered Multiphasic VOx", ELECTRONIC MATERIALS LETTERS, vol. 14, no. 1, 10 January 2018 (2018-01-10), pages 14 - 22, XP036377297, DOI: 10.1007/S13391-017-7134-1
- HENNEN T ET AL: "Switching Speed Analysis and Controlled Oscillatory Behavior of a Cr-Doped V2O3 Threshold Switching Device for Memory Selector and Neuromorphic Computing Application", 2019 IEEE INTERNATIONAL MEMORY WORKSHOP, 12-15 MAI 2019, MONTEREY, CA, 2019, XP033563761, DOI: 10.1109/IMW.2019.8739556
- WONG F J ET AL: "Bipolar resistive switching in room temperature grown disordered vanadium oxide thin-film devices", SOLID-STATE ELECTRONICS, vol. 87, 22 May 2013 (2013-05-22), pages 21 - 26, XP093205080, DOI: 10.1016/j.sse.2013.04.032
- WEI X-Y ET AL: "Analysis of the resistive switching behaviors of vanadium oxide thin film", CHINESE PHYSICS B, vol. 22, no. 3, 037201, 14 March 2013 (2013-03-14), XP020241966, DOI: 10.1088/1674-1056/22/3/037201
- ZHANG K-L ET AL: "Modeling of conducting bridge evolution in bipolar vanadium oxide-based resistive switching memory", CHINESE PHYSICS B, vol. 22, no. 9, 097101, 25 September 2013 (2013-09-25), XP020250402, DOI: 10.1088/1674-1056/22/9/097101
- VEYRET K ET AL: "Innovative switching mechanism, performance investigations and scaling effects in a-V2O3 based ReRAM devices", 2024 IEEE SILICON NANOELECTRONICS WORKSHOP, 15-16 JUNE 2024, HONOLULU, HI, USA, 15 June 2024 (2024-06-15), pages 81 - 82, XP034679289, DOI: 10.1109/SNW63608.2024.10639229

## Description

### DOMAINE TECHNIQUE DE L'INVENTION

Le domaine technique de l'invention est celui des mémoires résistives. La présente invention concerne une cellule mémoire résistive non volatile et son procédé de fabrication.

### ARRIERE-PLAN TECHNOLOGIQUE DE L'INVENTION

Pour des applications qui nécessitent un stockage de l'information même lorsque la tension est coupée, des mémoires non volatiles de type EEPROM ou FLASH sont classiquement utilisées. Ces mémoires présentent toutefois des inconvénients tels que des temps d'écriture longs, une densité de points mémoire limitée par la taille des transistors utilisés ou encore un nombre de cycles de réécriture limité.

Plus récemment, les mémoires non volatiles résistives constituent une alternative prometteuse aux mémoires de type FLASH ou EEPROM.

Les mémoires résistives reposent sur l'utilisation d'un milieu actif dont la résistance électrique dépend de la tension électrique appliquée aux bornes du matériau. En d'autres termes une cellule mémoire résistive présente deux états : un état HRS (« High Resistive State » selon la terminologie anglaise) correspondant à un état hautement résistif et un état LRS (« Low Resistive State » selon la terminologie anglaise) correspondant à un état faiblement résistif. Le milieu actif est inséré entre deux électrodes permettant l'application d'une tension électrique et assurant la lecture et l'écriture de l'état de la cellule mémoire résistive.

Selon le type de matériau actif utilisé, différents types de mémoire résistive peuvent être réalisées : matériaux à changement de phase (mémoires PCRAM ou « Phase Change RAM » également appelée PCM « Phase Change Memory »), à conduction ionique (mémoires CBRAM ou « Conductive Bridging RAM »), à oxydes métalliques (mémoires OxRAM ou « Oxide Resistive RAM »), magnétiques (mémoires MRAM ou « Magnetic RAM), magnétiques à transfert de spin (mémoires STTRAM ou « Spin Torque Transfer RAM ») ou isolants de Mott.

Les mémoires dites « de Mott » sont basées sur l'utilisation d'une couche active réalisée dans des matériaux isolants de Mott qui sont des matériaux qui d'après la théorie des bandes, devraient être conducteurs, mais en réalité se trouvent isolants à cause de fortes corrélations électroniques. Il est possible de faire passer le matériau de cet état isolant de Mott à un état métallique en appliquant une pression ou un champ électrique. Des exemples de ces mémoires Mott à base de VOₓ peuvent être retrouvés dans J Tranchant et al, 2018 IEEE INTERNATIONAL MEMORY WORKSHOP, Kyoto, Japon, 13-16 mai 2018 et S Won et al, ELECTRONIC MATERIALS LETTERS, vol. 14, no. 1 (2018), pages 14-22.
Dans les mémoires de Mott, une tension de SET appliquée aux électrodes de la mémoire permet de contrôler la transition de l'état isolant vers l'état métallique et une tension de RESET appliquée aux électrodes de la mémoire permet de contrôler la transition de l'état métallique à l'état isolant. On notera que les mémoires de Mott sont du type apolaire : dit autrement, peu importe le signe de la tension de SET ou RESET appliquée contrairement à des mémoires résistives de type bipolaire telles que les mémoires CBRAM par exemple, pour lesquelles il est nécessaire d'inverser le signe du potentiel appliqué aux électrodes selon que l'on cherche à réaliser une opération de SET ou de RESET. Des mémoires CBRAM à base de VOₓ sont connues de CN 102130296 A et K-L Zhang et al, CHINESE PHYSICS B, vol. 22, no. 9 (2013), 097101, par exemple.

Parmi les isolants de Mott, le sesquioxyde de vanadium cristallisé dans lequel on substitue une partie des atomes de vanadium par du chrome, par exemple le (V₁₋ₓCrₓ)₂O₃ (avec x ≥ 0.011), est un isolant de Mott dans lequel le phénomène de commutation résistive réversible induit par impulsion électrique est possible. Il est donc utilisé pour la réalisation de mémoires de Mott. L'avantage des mémoires résistives de Mott par rapport à d'autres mémoires résistives RRAM est qu'elles sont basées uniquement sur des phénomènes de transition électronique. Contrairement à certaines autres mémoires résistives avec un état initial où le matériau actif de la zone active de mémorisation est isolant (état pristine), la mémoire de Mott ne nécessite pas d'étape d'initialisation (i.e. une étape durant laquelle un premier stress électrique doit donc être appliqué sur la cellule mémoire vierge afin de générer l'état LRS pour la première fois).

La réalisation de couches fines de (V₁₋ₓCrₓ)₂O₃ (avec x ≥ 0.011) cristallisé utilisable dans une mémoire de Mott a été obtenue par des techniques de dépôt physique par phase vapeur PVD (« Physical Vapor Deposition » selon la terminologie anglaise) telles que la pulvérisation cathodique magnétron : pour ce faire, une abrasion de cibles à base de vanadium et chrome par des ions argon sous pression d'oxygène est réalisée afin d'obtenir un oxyde de vanadium amorphe, non stœchiométrique en oxygène et en chrome. Or le matériau (V₁₋ₓCrₓ)₂O₃ (avec x ≥ 0.011) utilisé dans les mémoires de Mott doit être cristallisé et parfaitement stœchiométrique. En conséquence, l'étape de dépôt par PVD est suivie d'une étape de recuit à une température supérieure ou égale à 500°C sous atmosphère réductrice. Une telle technique présente certains inconvénients dans une logique d'intégration CMOS en back end dans laquelle le budget thermique ne doit pas dépasser 450°C.

### RESUME DE L'INVENTION

L'invention offre une solution aux problèmes évoqués précédemment, en proposant une cellule mémoire résistive non volatile à base d'oxyde de vanadium qui soit notamment plus facilement intégrable dans un processus back end CMOS.

On entend par cellule mémoire résistive un dispositif électrique possédant un premier état hautement résistif ou état HRS ou encore état RESET et un deuxième état faiblement résistif ou état LRS ou encore état SET. La non-volatilité réside dans le fait que la cellule mémoire conserve son état résistif une fois que la tension de SET ou de RESET n'est plus appliquée.

L'invention a plus spécifiquement pour objet une cellule mémoire résistive selon la revendication indépendante 1, en particulier comportant :
- Une électrode inférieure à base de nitrure de titane,
- Une électrode supérieure,
- Une couche active ayant une première surface de contact avec l'électrode inférieure et une deuxième surface de contact avec l'électrode supérieure, ladite couche active comportant une zone, dite zone locale, ladite zone locale étant dans un matériau comportant du vanadium, du titane et de l'oxygène s'étendant depuis la première surface de contact, le reste de la couche active étant réalisée en oxyde de vanadium V₂O₃ conducteur.

On entend par oxyde de vanadium V₂O₃ conducteur un matériau V₂O₃ avec une résistivité inférieure ou égale à 0.1 ohm.cm.

Contrairement aux mémoires de Mott qui reposent sur l'utilisation d'un matériau (V₁₋ₓCrₓ)₂O₃ (avec x ≥ 0.011) dans la phase isolant de Mott, la cellule mémoire selon l'invention utilise une couche active principalement réalisée en V₂O₃ avec une zone singulière dans cette couche au niveau de l'interface entre la couche active et l'électrode inférieure : cette zone de la couche active au niveau de l'électrode inférieure n'est pas en oxyde de vanadium V₂O₃ conducteur et comporte un matériau hautement résistif incluant du vanadium, du titane et de l'oxygène. De façon surprenante, le demandeur s'est aperçu qu'une telle cellule présentait un fonctionnement de mémoire résistive permettant de commuter entre un état hautement résistif HRS et un état bassement résistif LRS. Ces opérations de RESET et de SET se font par l'application d'une différence de potentiel de polarité inverse entre les électrodes supérieure et inférieure de la cellule mémoire : en d'autres termes, contrairement aux mémoires de Mott, la cellule selon l'invention possède un fonctionnement bipolaire.

De façon surprenante, la demanderesse a découvert le fonctionnement de l'invention en voulant réaliser un matériau V₂O₃ isolant pour une mémoire de Mott par une technique de dépôt par faisceau d'ions IBD (« Ion Beam Deposition » selon la terminologie anglaise) ; en utilisant cette technique de dépôt, les inventeurs ont obtenu un matériau V₂O₃ conducteur et donc non adapté à une mémoire de Mott connue de l'état de la technique. Toutefois, en réalisant des opérations de cycles RESET/SET sur un empilement incluant une couche active de V₂O₃ conducteur telle que déposée prise entre deux électrodes, les inventeurs ont constaté un fonctionnement de type mémoire résistive. Ils ont par ailleurs observé que, lors de la première opération d'initialisation, la couche de V₂O₃ conducteur passait d'un état bassement résistif LRS à un état hautement résistif HRS avec l'apparition de cette zone locale singulière à base titane, d'oxygène et de vanadium hautement résistive dans la couche de V₂O₃. Cette structure particulière de cellule incluant cette zone formée d'un alliage V-Ti-O confère à la cellule selon l'invention un rôle de cellule mémoire résistive bipolaire. Nous reviendrons dans la suite de la description sur la structure de cette cellule, sur son fonctionnement et sur le mécanisme de création de cette zone localisée en V-Ti-O, probablement liée à un fort échauffement au niveau de l'interface entre l'électrode inférieure et la couche active au moment de l'étape de d'initialisation. On notera que les techniques de dépôt IBD permettent la réalisation de couches de V₂O₃ conducteur cristallines ou partiellement cristallines à des températures de cristallisation supérieur à 280°C, donc parfaitement compatibles avec une intégration back end CMOS.

On notera que les termes « inférieure » et « supérieure » sont bien entendu utilisés pour une meilleure compréhension de l'invention mais restent relatifs de sorte que l'électrode inférieure peut être considérée comme l'électrode supérieure et l'électrode supérieure comme l'électrode inférieure en retournant la cellule mémoire tout en restant dans le champ d'application de la cellule mémoire selon l'invention.

On notera que la cellule selon l'invention s'applique à d'autres matériaux d'électrode inférieure choisis parmi les matériaux suivants : Ta, TaN, Cu, W, Pt, Au ou Ag. Dans ce cas, la zone locale comporte, en plus du vanadium et de l'oxygène, du Ta (dans le cas d'une électrode inférieure en Ta ou TaN), du Cu (dans le cas d'un électrode inférieure en Cu), du W (dans le cas d'une électrode inférieure en W), du Pt (dans le cas d'une électrode inférieure en Pt), de l'Au (dans le cas d'une électrode inférieure en Au) ou de l'Ag (dans le cas d'une électrode inférieure en Ag).

De même, la cellule selon l'invention s'applique à tout type de couche active réalisée en oxyde de vanadium conducteur. En d'autres termes, la couche active peut être en V₂O₃ conducteur mais également en V₆O₁₃ conducteur, en VO₂ dans sa phase rutile métallique ou en V₂O_{3-δ}:Cr (i.e. V₂O₃ sous-stœchiométrique substitué en Cr par rapport au vanadium). Plus généralement, tous les oxydes de vanadium du type VₙO₂ₙ₋₁ conducteur (avec n entier supérieur ou égal à 2) ont des transitions résistives en température et deviennent conducteurs au-delà d'une certaine température : ils peuvent donc s'appliquer à la cellule selon l'invention dans le cas où cette température est atteinte lors de l'opération de la cellule mémoire. Encore plus généralement, tous les oxydes de vanadium rendus conducteurs par quelques procédés possibles (température, champ électrique, impulsion laser,..) peuvent s'appliquer à la cellule selon l'invention.

Outre les caractéristiques qui viennent d'être évoquées dans les paragraphes précédents, la cellule mémoire selon l'invention peut présenter une ou plusieurs caractéristiques complémentaires parmi les suivantes, considérées individuellement ou selon toutes les combinaisons techniquement possibles :
- L'électrode supérieure est à base de nitrure de titane ;
- la zone locale est sans contact avec la deuxième surface de contact ;
- l'épaisseur de la couche active est comprise entre 5 et 200 nm ;
- la zone locale présente une forme de dôme dont la section parallèle au plan des couches diminue depuis la première surface de contact ;
- l'électrode inférieure à base de nitrure de titane comporte du vanadium, du titane et de l'oxygène dans une zone localisée à proximité de la première surface de contact. Dans ce cas, la zone locale présente par exemple une forme de champignon avec un dôme dont la section parallèle au plan des couches diminue depuis la première surface de contact ;
- la première surface de contact présente une aire inférieure ou égale à 9000 nm² et préférentiellement inférieure ou égale à 6000 nm²;
- la première surface de contact est égale à la surface supérieure de l'électrode inférieure et strictement inférieure à la surface totale inférieure de la couche active ;
- l'électrode inférieure présente une forme de parallélépipède rectangle de type « Wall » ou une forme en L ;
- l'oxyde de vanadium V₂O₃ conducteur est cristallin ou partiellement cristallin;
- la zone locale est réalisée dans un matériau cristallin ou partiellement cristallin.

Un autre objet de l'invention est un procédé de fabrication d'une cellule mémoire selon la revendication indépendante 14, en particulier comportant les étapes suivantes :
- Réalisation d'une électrode inférieure à base de nitrure de titane ;
- Dépôt d'une couche réalisée en oxyde de vanadium V₂O₃ ayant une première surface de contact avec l'électrode inférieure ;
- Réalisation d'une électrode supérieure ;
ledit procédé comportant une étape, dite étape d'initialisation, consistant à injecter un courant à travers l'empilement formé par l'électrode inférieure, la couche de V₂O₃ et l'électrode supérieure, la densité de courant étant choisie pour créer ladite zone locale comportant du vanadium, du titane et de l'oxygène.

Outre les caractéristiques qui viennent d'être évoquées dans les paragraphes précédents, le procédé de fabrication selon l'invention peut présenter une ou plusieurs caractéristiques complémentaires parmi les suivantes, considérées individuellement ou selon toutes les combinaisons techniquement possibles :
- Le procédé comporte une étape de traitement thermique pendant ou après ladite étape de dépôt jusqu'à rendre conducteur ladite couche en oxyde de vanadium V₂O₃ ;
- ladite couche déposée est réalisée en oxyde de vanadium V₂O₃ amorphe ;
- la densité de courant de l'étape d'initialisation est supérieure ou égale à 50.10⁶ A/cm² ;
- le dépôt de la couche réalisée en oxyde de vanadium V₂O₃ est réalisé par une technique de dépôt par faisceau d'ions ;
- le procédé comporte une étape de nettoyage de l'électrode inférieure par décapage ionique (Ar, Xe, ou Kr) in situ (i.e. dans le même équipement que l'étape de dépôt du V₂O₃, sans remise à l'air) avant l'étape de dépôt de V₂O₃;
- la réalisation de l'électrode supérieure peut être réalisée in situ ou après remise à l'air.

### BREVE DESCRIPTION DES FIGURES

Les figures sont présentées à titre indicatif et nullement limitatif de l'invention.
La [Fig 1] représente schématiquement une vue à 3D de la cellule mémoire selon l'invention.
La [Fig 2] représente le comportement lors de 1000 cycles d'écriture (SET) et d'effacement (RESET) d'une cellule mémoire selon l'invention.
La [Fig 3] montre une image STEM en champ sombre d'une cellule mémoire avant initialisation.
La [Fig 4] montre une image STEM en champ sombre d'une cellule mémoire selon l'invention.
Les [Fig 5], [Fig 6], [Fig 7] et [Fig 8] montrent des analyses par spectroscopie X à dispersion d'énergie EDX et par microscopie TEM d'une cellule mémoire selon l'invention.
Les [Fig 9], [Fig 10], [Fig 11] et [Fig 12] [Fig 13], [Fig 14] et [Fig 15] montrent des résultats de cycles d'écriture (SET) et d'effacement (RESET) pour des cellules selon l'invention avec différentes surfaces de contact et différentes épaisseurs de couche active.
La [Fig 16] illustre schématiquement le fonctionnement d'une cellule mémoire selon l'invention.
La [Fig 17] montre une image STEM en champ sombre et les analyses de spectroscopie de perte d'énergie d'électrons (electron energy loss spectroscopy, EELS en anglais) montrant l'absence d'oxygène et de vanadium dans la partie supérieure de l'électrode inférieure de la cellule mémoire avant initialisation.
La [Fig 18] montre une image STEM en champ sombre et les analyses EELS montrant la présence d'oxygène et de vanadium dans la partie supérieure de l'électrode inférieure de la cellule mémoire selon l'invention.
La [Fig 19] montre une image STEM en champ sombre d'une cellule mémoire selon l'invention.
La [Fig 20] montre une analyse par spectroscopie X à dispersion d'énergie EDX et par microscopie TEM illustrant l'appauvrissement en vanadium dans la zone localisée de la cellule mémoire selon l'invention.

L'invention et ses différentes applications seront mieux comprises à la lecture de la description qui suit et à l'examen des figures qui l'accompagnent.

### DESCRIPTION DETAILLEE DE L'INVENTION

Sauf précision contraire, un même élément apparaissant sur des figures différentes présente une référence unique.

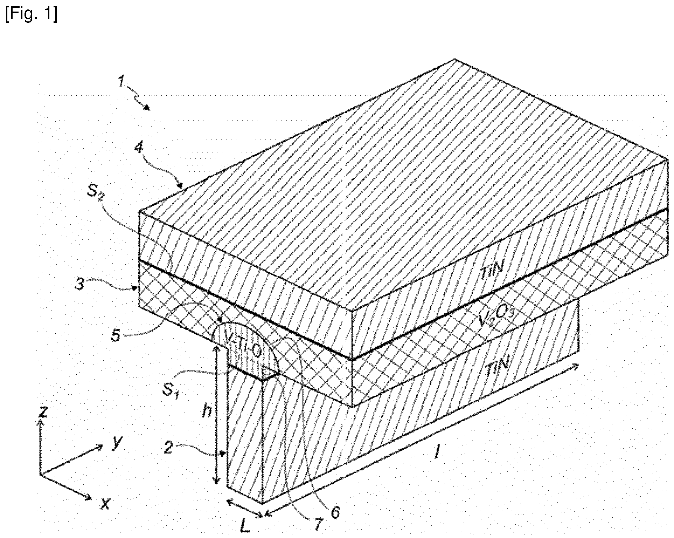

La [Fig 1] représente schématiquement en trois dimensions une cellule mémoire 1 selon l'invention dans un repère Oxyz, le plan Oxy définissant le plan des couches, l'axe Oz définissant la direction de la hauteur des couches, l'axe Oy définissant la direction de la longueur des couches et l'axe Ox définissant la direction de la largeur des couches.

La cellule mémoire 1 comporte :
- Une électrode inférieure 2 en TiN ;
- Une électrode supérieure 4 en TiN ;
- Une couche active 3 principalement réalisée en oxyde de vanadium conducteur V₂O₃ et cristallisée ou partiellement cristallisée mais avec une zone localisée singulière 5 comportant du titane, du vanadium et de l'oxygène sur laquelle nous reviendrons dans ce qui suit.

La surface supérieure de la couche active 3 est en contact avec la surface inférieure de l'électrode supérieure 4, selon une surface de contact S2.

La surface inférieure de la couche active 3 est en contact avec la surface supérieure de l'électrode inférieure 2, selon une surface de contact S1.

L'électrode inférieure 2 a une architecture de type « wall », c'est-à-dire qu'elle forme un mur parallélépipédique de longueur |, de largeur L et de hauteur h : l'aire IxL de la surface supérieure de l'électrode est strictement inférieure à l'aire de la surface inférieure de la couche active 3 ; en d'autres termes, l'aire de la surface de contact S1 est égale à IxL. L'aire de la surface de contact S1 est strictement inférieure à l'aire de la surface de contact S2 (i.e. l'électrode inférieure 2 présente ici une largeur L bien inférieure à la largeur de l'électrode supérieure 4 et une longueur l inférieure ou égale à celle de l'électrode supérieure 4). On notera que l'électrode inférieure 2 peut également avoir d'autres formes telles qu'une forme en L avec une première partie supérieure identique au mur présenté ci-dessus et une seconde partie inférieure de forme parallélépipédique parallèle au plan des couches.

La couche active 3 de la cellule mémoire 1 selon l'invention peut être notamment réalisée par le dépôt d'une couche de V₂O₃ conducteur cristallisée ou partiellement cristallisée en utilisant une technique de dépôt par faisceau d'ions IBD (« Ion Beam Deposition » selon la terminologie anglaise). Le dépôt consiste en la pulvérisation d'une cible de vanadium par un faisceau d'ions d'argon. La chambre de dépôt est mise sous vide (5x10⁻⁸ Torr) avant le dépôt. Durant le dépôt, la pression partielle d'oxygène est contrôlée et influe sur le degré d'oxydation du matériau final. Le dépôt s'effectue à température ambiante et ne nécessite pas nécessairement de traitement thermique, rendant ainsi le procédé d'obtention de la cellule mémoire selon l'invention compatible avec une intégration back end CMOS. Même avec des recuits de cristallisation, ces derniers restent inférieurs à 450°C qui est la température maximale d'intégration CMOS en back end.

Selon un autre mode de réalisation, après le dépôt IBD le V₂O₃ est isolant (résistivité de l'ordre de quelques ohms.cm à quelques dizaines d'ohms.cm) et a un caractère amorphe (pas de pics de diffraction détectables en caractérisation XRD). Optionnellement, un recuit à une température inférieure à 450°C et préférentiellement supérieure ou égale à 280°C est réalisé afin d'obtenir un matériau V₂O₃ conducteur (i.e. avec une résistivité inférieure ou égale à 0,1 ohm.cm) cristallisé ou partiellement cristallisé. On notera que l'étape de recuit peut être réalisée durant la fabrication de la cellule mémoire de type wall qui met en œuvre certaines étapes technologiques, telles que les dépôts de diélectriques d'encapsulation, à des températures de l'ordre de 300°C, températures auxquelles le V₂O₃ IBD amorphe cristallise.

La réalisation des électrodes supérieure et inférieure à base de nitrure de titane est faite selon des techniques bien connues de l'homme du métier. A ce stade, la couche active est exclusivement en V₂O₃ conducteur cristallisé ou partiellement cristallisé alors que nous avons vu que la couche active 3 selon l'invention comporte une zone localisée singulière 5 comportant du titane, du vanadium et de l'oxygène. Le V₂O₃ conducteur pourrait également être obtenu par d'autres techniques de dépôt telles qu'un dépôt PVD. Il est également possible d'utiliser du V₂O₃ conducteur cristallisé dans lequel une partie du vanadium est substituée par du chrome tant que le de V₂O₃ reste conducteur.

Pour obtenir cette zone localisée singulière 5, il convient de réaliser une étape d'initialisation à travers l'empilement formé par les deux électrodes (l'électrode inférieure ayant la forme du mur 2) et la couche en V₂O₃ conducteur cristallisé ou partiellement cristallisé. On comprend qu'à ce stade appelé état pristine (i.e. état vierge), l'empilement est dans un état bassement résistif LRS puisque la couche en V₂O₃ est conductrice. L'étape d'initialisation consiste à injecter un courant avec une forte densité de courant, préférentiellement strictement supérieure à 50.10⁶ A/cm₂ en appliquant une tension positive entre la première et la deuxième électrode (tension d'initialisation). Cette étape va entraîner le basculement de l'empilement de son état pristine LRS vers un état hautement résistif HRS et va entraîner l'apparition de la zone localisée 5 représentée à la figure 1. L'apparition de cette zone incluant du titane, de l'oxygène et du vanadium peut s'expliquer par l'injection d'un courant de forte densité au niveau de la surface de contact S1 entre la première électrode 2 et la couche active 3. L'aire de la surface supérieure IxL de la première électrode en forme de mur est choisie suffisamment faible pour entraîner un échauffement local au niveau de S1 et de la zone à proximité de S1 (i.e. au-dessus dans la zone active 3 et en-dessous dans la première électrode 2). Des simulations électrothermiques à l'aide de l'outil COMSOL montrent que la température atteinte à l'interface entre l'électrode inférieure wall 2 et la couche active 3 peut atteindre 2000°K : cet échauffement local entraîne la création de la zone 5 fait d'un alliage V-Ti-O comportant une première partie 6 en forme de dôme fait s'étendant depuis la première surface de contact S1 et remontant à l'intérieur de la couche active 3 et une second partie 7 localisée sur l'extrémité supérieure de l'électrode inférieure 2. En d'autres termes, la zone 5 a la forme d'un champignon avec son chapeau dans la zone active 3 et son pied dans le haut de l'électrode inférieure 2.

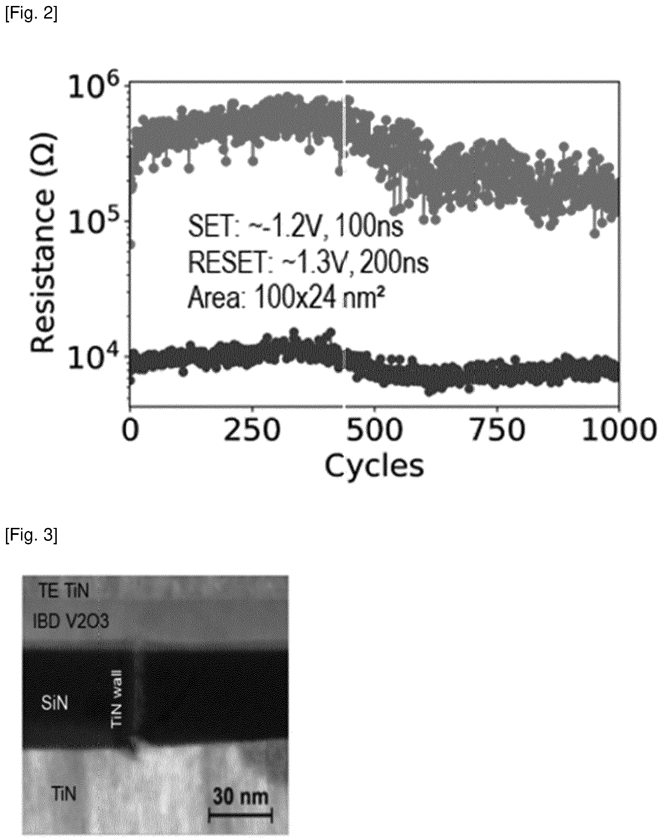

Une fois cette opération d'initialisation réalisée et la zone 5 à base V-Ti-O créée, la cellule mémoire 1 se comporte comme une cellule mémoire résistive de type bipolaire. En d'autres termes, l'application d'une impulsion de tension de SET va permettre de réaliser une opération de SET et de basculer dans un état bassement résistif LRS. Puis l'application d'une impulsion de tension de RESET de signe opposé à la tension de SET va permettre de basculer dans un état hautement résistif HRS. La cellule mémoire a un comportement non volatil de sorte qu'elle conserve la valeur de la résistance une fois que la tension de SET ou RESET n'est plus appliquée. La figure 2 montre le comportement lors de 1000 cycles d'écriture (SET) et d'effacement (RESET) d'une cellule mémoire selon l'invention avec une épaisseur de la couche active de 50 nm, une longueur l de l'électrode inférieure de type wall de 100nm et une largeur L de 24 nm. L'impulsion de SET est de 1.2V pendant 100 ns et l'impulsion de polarité opposée de RESET de polarité opposée à l'impulsion de SET est de 1.3 V pendant 200 ns. On observe une bonne tenue en endurance (i.e. lors de 1000 cycles SET/RESET) de la cellule mémoire selon l'invention qui commute d'une résistance LRS de quelques kOhms à une résistance HRS de l'ordre de quelques centaines de kOhms. Les résultats d'endurance montrent une faible dispersion des états résistifs comparée à d'autres types de mémoires résistives telles que les CBRAM ou les OxRAM. On note que les impulsions de SET et de RESET ont des amplitudes inférieures à 2 V et des durées inférieures à 1 µs.

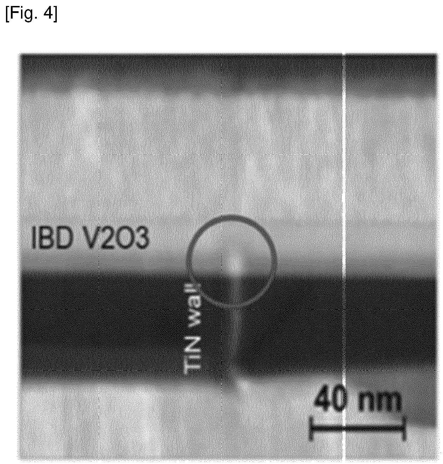

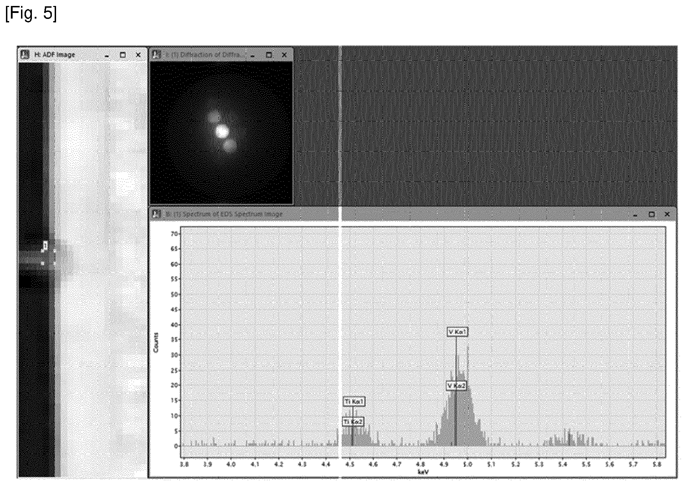

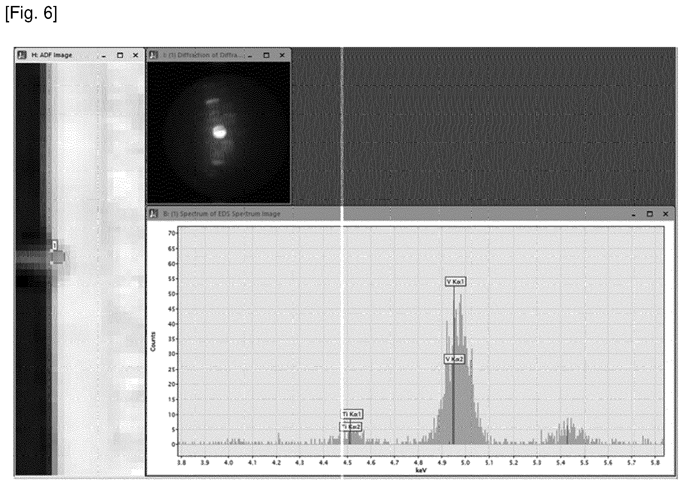

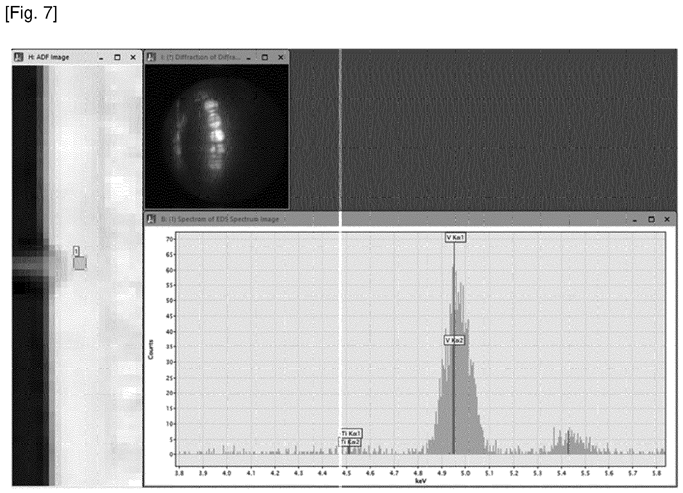

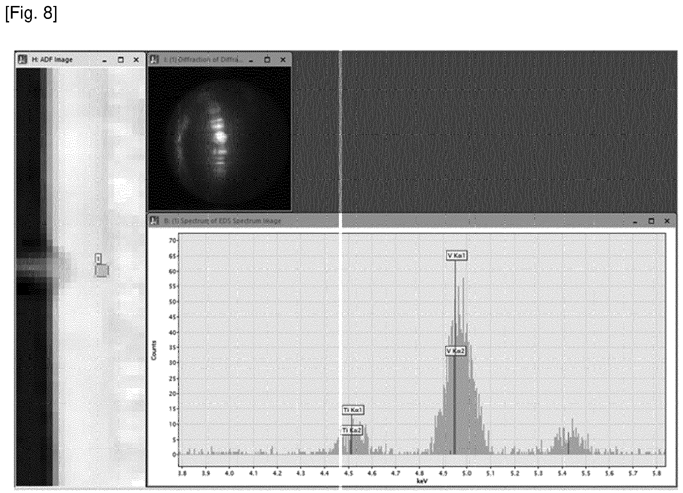

La mise en évidence de la zone localisée 5 a été réalisée par des clichés de microscopie électronique en transmission à balayage STEM (« Scanning Transmission Electron Microscope » selon la terminologie anglaise) illustrés aux figures 3 et 4. La figure 3 montre un cliché STEM en champ sombre d'une cellule avant initialisation et la figure 4 montre un cliché STEM en champ sombre d'une cellule mémoire selon l'invention après l'étape d'initialisation et 40 cycles de programmation. Le cercle représenté en figure 4 entoure la zone particulière 5 de la figure 1 créée après l'étape d'initialisation, au-dessus de l'électrode inférieure wall en TiN. Cette zone 5, non présente sur la figure 3 avant l'étape d'initialisation, est une zone altérée de quelques nanomètres d'épaisseur de forte densité atomique en forme de dôme dont la section parallèle au plan des couches diminue depuis la première surface de contact. On constate que cette zone 5 est bien localisée à l'intérieur de la couche active 3 en V₂O₃ conducteur et présente une densité atomique différente de celle la partie en V₂O₃ conducteur. On note par ailleurs que cette zone 5 part bien de la surface de contact entre la couche active 3 et l'électrode inférieure 2 en TiN puis remonte dans l'épaisseur de la couche active 3 sans atteindre la surface supérieure de la couche active 3 de sorte que la zone 5 n'est pas en contact avec l'électrode supérieure 4 : la zone 5 localisée demeure présente durant les différents cycles de programmation et peut être vue comme une zone en contact avec l'électrode inférieure 2 dans une zone plus globale en V₂O₃ conducteur. Le fait que la cellule mémoire selon l'invention soit dans un état hautement résistif après l'étape d'initialisation indique que la zone 5 est réalisée dans un matériau hautement résistif. Ainsi, l'étape d'initialisation induit un changement de composition du matériau V₂O₃ conducteur dans cette zone et la formation d'un alliage très résistif à base de vanadium, de titane et d'oxygène. Ce résultat est conforté par des données de la littérature qui indiquent des résistivités élevées de l'ordre de 10⁵ Ohm.cm pour les alliages TiO₂-V₂O₃-V₂O₅ et surtout par des analyses par spectroscopie X à dispersion d'énergie EDX (« Energy Dispersive X-ray » selon la terminologie anglaise) illustrées aux figures 5 à 8 qui démontrent la présence de titane dans cette zone particulière 5. Sur chacune des figures 5 à 8, sont représentés :
- Sur la partie droite une image par microscopie électronique en transmission TEM (« Transmission Electron Microscopy » selon la terminologie anglaise) de la cellule mémoire selon l'invention ;
- Sur la partie haute, un cliché de diffraction de la zone entourée par le rectangle présent sur l'image TEM ;
- Sur la partie basse, le spectre EDX de la zone entourée par le rectangle présent sur l'image TEM.

Les analyses TEM et EDX montrent la création d'une zone locale en forme de dôme 6 comportant du vanadium, du titane et de l'oxygène. La présence de vanadium et d'oxygène n'est pas surprenante dans la mesure où cette zone se trouve dans une couche initialement en V₂O₃. En revanche, les analyses EDX montrent clairement la présence de titane dans la première électrode de type wall mais aussi dans la zone locale située immédiatement au-dessus de la première électrode et notée 5 sur la figure 1. On constate que la quantité de titane est plus importante au niveau de l'interface de contact S1 entre la couche active 3 et l'électrode inférieure 2 puis diminue progressivement jusqu'à disparaître dans la couche active 3 comportant uniquement du V₂O₃ sur sa partie haute : cette constatation permet de bien identifier la zone singulière 5 qui ne s'étend pas sur toute la hauteur de couche active 3. La présence de titane se manifeste à nouveau au niveau de l'électrode supérieure 4.

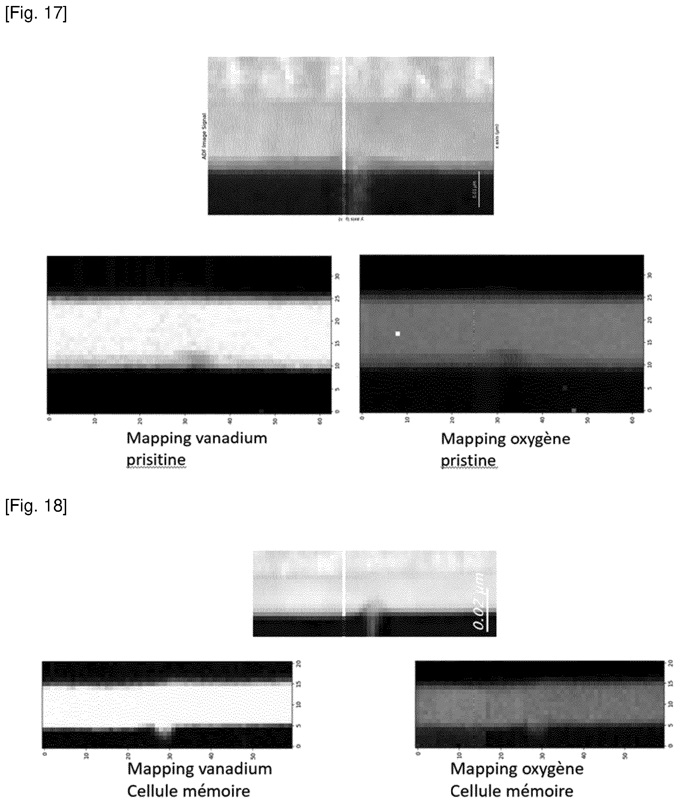

Les figures 17 et 18 montrent des analyses EELS par spectrométrie de pertes d'énergie des électrons illustrant la répartition du vanadium et de l'oxygène respectivement pour un empilement d'une cellule mémoire selon l'invention avant l'étape d'initialisation et pour une cellule mémoire selon l'invention une fois formée. Pour chaque figure 17 et 18, la partie haute montre une image par microscopie électronique en transmission de la zone analysée : on voit l'électrode inférieure ainsi que la couche active. En figure 17, les clichés EELS de l'empilement non initialisé (en bas à gauche pour le vanadium et en bas à droite pour l'oxygène) montrent la présence de vanadium et d'oxygène uniquement dans la couche active. En revanche, en figure 18, les clichés EELS de la cellule mémoire selon l'invention (en bas à gauche pour le vanadium et en bas à droite pour l'oxygène) montrent la présence d'oxygène et de vanadium, en plus du titane, dans la partie haute 7 de l'électrode inférieure 2. On a donc bien une zone locale 5 en forme de champignon (dôme 6 et partie supérieure 7 de l'électrode inférieure) comportant du vanadium, du titane et de l'oxygène.

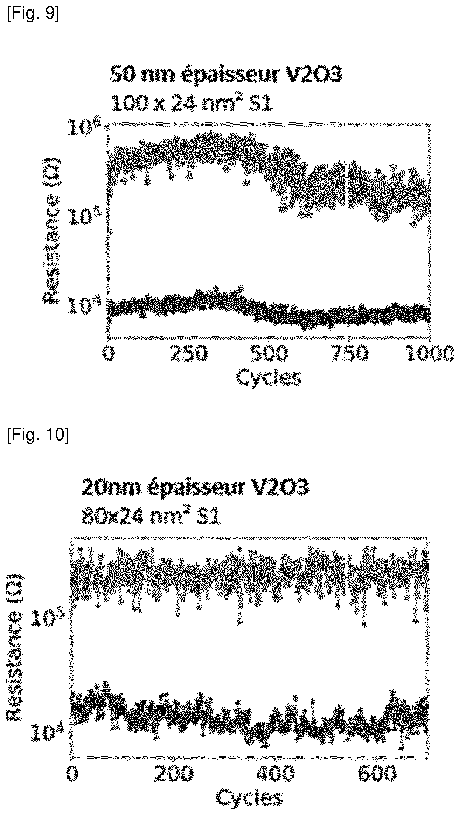

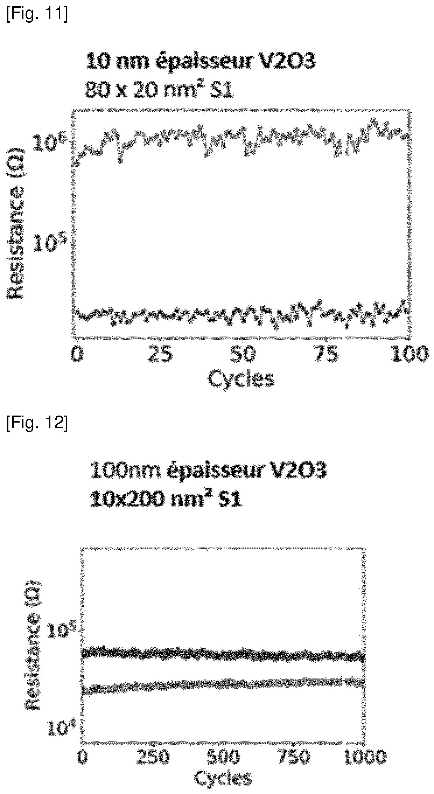

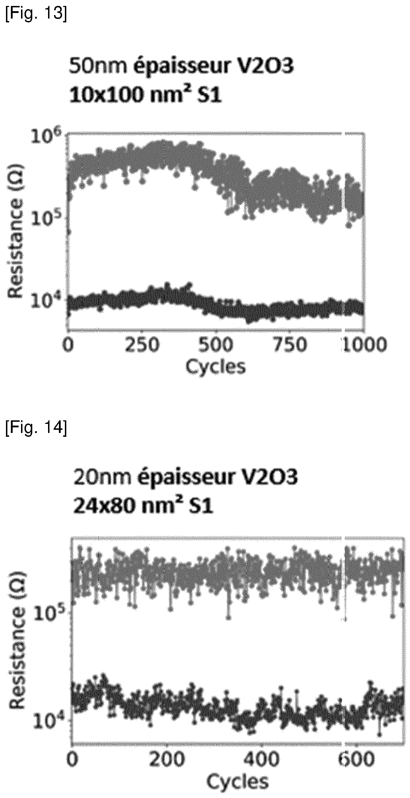

Les figures 9 à 15 montrent des résultats de cyclage pour des cellules selon l'invention avec différentes surfaces de contact S1 et différentes épaisseurs de couche active 3. Ces résultats montrent que l'épaisseur de la couche de V₂O₃ conducteur a peu d'impact sur le comportement mémoire de la cellule selon l'invention : cette épaisseur est cependant préférentiellement comprise entre 5 et 200 nm et encore plus avantageusement entre 10 et 100 nm. La surface de contact S1 (i.e. correspondant à la surface supérieure de l'électrode inférieure wall 2) est quant à elle préférentiellement inférieure à 6000 nm².

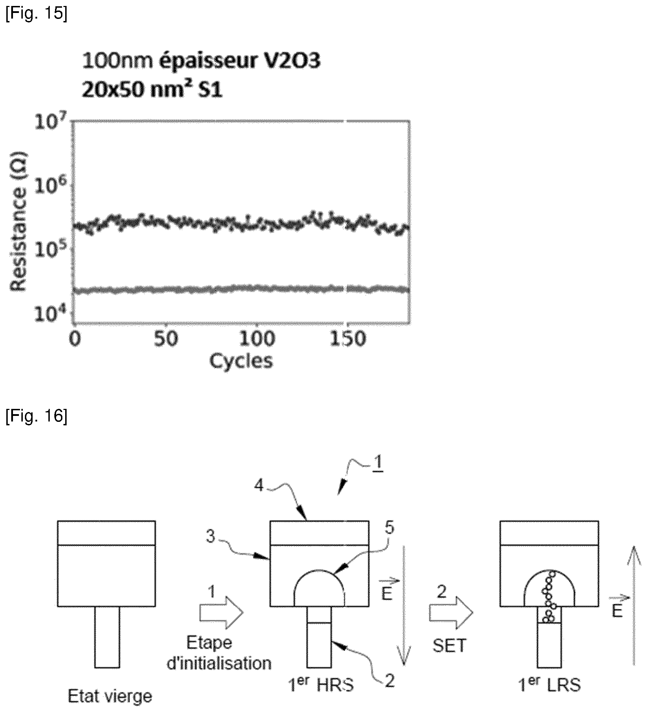

La figure 16 illustre schématiquement une explication du mode de fonctionnement de la cellule selon l'invention. La partie gauche de la figure montre l'empilement avant l'étape d'initialisation sans la présence de la zone locale très résistive 5 : dans cette configuration vierge, l'empilement est bassement résistif. Après l'étape d'initialisation permettant de passer d'un état vierge bassement résistif à un état hautement résistif HRS, la cellule mémoire selon l'invention 1 est créée avec la présence de la zone singulière 5 très résistive comportant notamment du Ti, du V et de l'O. Ensuite, la cellule mémoire résistive pourrait se comporter comme une mémoire résistive filamentaire avec la zone singulière 5 jouant le rôle d'électrolyte solide. Ainsi, lors de l'application d'un potentiel positif sur l'électrode inférieure 2, des ions mobiles à base de titane se déplaceraient depuis l'électrode inférieure 2 sous l'effet du champ électrique appliqué aux électrodes entraînant la croissance d'un filament métallique de titane à l'intérieur de la zone singulière 5 à base de Ti, V et O. Le reste de la couche active 3 étant en oxyde métallique, la cellule mémoire selon l'invention passe alors dans un état bassement résistif LRS. Le passage à l'état hautement résistif HRS consiste à appliquer une tension négative sur l'électrode inférieure 2, entraînant la dissolution totale ou partielle du filament conducteur.

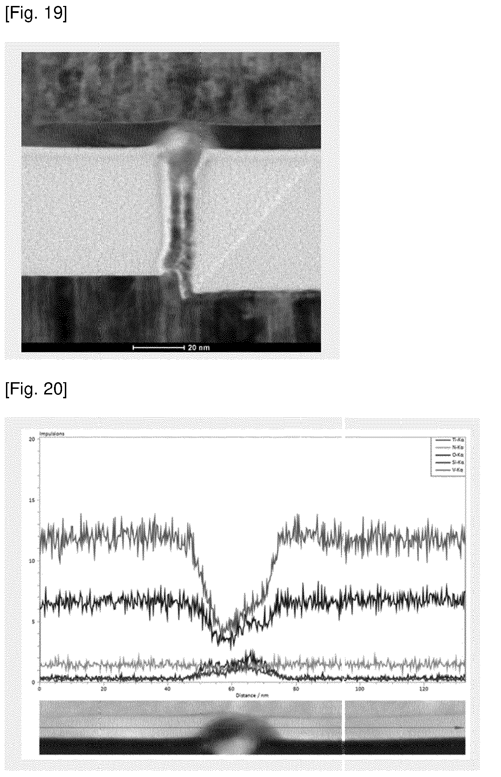

On notera que, selon un autre mode de réalisation, la cellule mémoire selon l'invention est réalisée avec un empilement du type TiN/V₂O₃/TiN comprenant une couche active de V₂O₃ de 10 nm d'épaisseur et n'ayant pas subi de recuit. Après initialisation, la zone locale se forme en étant à la fois en contact avec la surface S1 de l'électrode inférieure mais aussi en contact avec la surface S2 de l'électrode supérieure. Ce phénomène est illustré par la figure 19 qui montre un cliché de la zone localisée 5 réalisé par microscopie électronique en transmission à balayage STEM, ladite zone s'étendant de la surface de l'électrode inférieure jusqu'à la surface de l'électrode supérieure.

La zone localisée ou dôme comprend en outre un appauvrissement (i.e. une déplétion) en volume d'atomes de vanadium supérieur ou égal à 20% (i.e. de l'ordre de 40%, voire davantage) comparé aux atomes de vanadium présents en volume dans le reste de la couche active en oxyde de vanadium. La présence de vides a également été observée. Cet appauvrissement en atomes de vanadium est illustré par la figure 20 correspondant à un spectre initialisé montrant la déplétion en vanadium au niveau de la zone localisée (cf. courbe la plus haute du spectre).

D'autres empilements de la cellule mémoire selon l'invention ont été réalisés avec une épaisseur e de la couche active, une longueur l et une largeur L de l'électrode inférieure de type wall :
- Electrode supérieure en TiN / couche active en V₂O₃ cristallin non stœchiométrique avec 10% de Cr substitué par rapport au vanadium (10% atomique de Cr par rapport à V+Cr soit 4% atomique de Cr par rapport à V+Cr+O) ayant une une épaisseur e respectivement égale à 5nm, 10nm ou 20nm / électrode inférieure de type wall en TiN ( avec une largeur L de l'ordre de 15nm et une longueur l variant de 40nm à 300nm)
- Electrode supérieure en TiN / couche active en V₂O₃ cristallin ayant une épaisseur de 20nm / électrode inférieure en TiN
- Electrode supérieure en TiN / couche active en V₂O₃ cristallin ayant une épaisseur e de 50nm / électrode inférieure de type wall en TiN ( avec une largeur L de l'ordre de 10nm et une longueur l variant de 40nm à 300nm)
- Electrode supérieure en TiN / couche active en V₂O₃ amorphe ayant une épaisseur e de 10nm / électrode inférieure de type wall en TiN ( avec une largeur L de l'ordre de 10nm et une longueur l variant de 40nm à 300nm)

## Revendications

1. Cellule mémoire résistive (1) comportant :
- Une électrode inférieure (2) à base de l'un des matériaux suivants : nitrure de titane TiN, nitrure de tantale TaN, tantale Ta, cuivre Cu, tungstène W, platine Pt, or Au ou argent Ag,
- Une électrode supérieure (4),
- Une couche active (3) ayant une première surface de contact (S1) avec l'électrode inférieure et une deuxième surface (S2) de contact avec l'électrode supérieure,
**caractérisée en ce que** ladite couche active (3) comporte une zone, dite zone locale (5), ladite zone locale étant dans un matériau comportant du vanadium, de l'oxygène et du Ti si le matériau de l'électrode inférieure est du TiN ou du Ta si le matériau de l'électrode inférieure est du TaN ou du Ta, ou du Cu si le matériau de l'électrode inférieure est du Cu, ou du W si le matériau de l'électrode inférieure est du W, ou du Pt si le matériau de l'électrode inférieure est du Pt, ou de l'Au si le matériau de l'électrode inférieure est de l'Au, ou de l'Ag si le matériau de l'électrode inférieure est de l'Ag, ladite zone locale s'étendant depuis la première surface (S1) de contact, le reste de la couche active étant réalisée en oxyde de vanadium conducteur.

2. Cellule mémoire selon la revendication précédente **caractérisée en ce que** l'électrode supérieure (4) est à base de nitrure de titane.

3. Cellule mémoire selon l'une des revendications précédentes **caractérisée en ce que** ladite zone locale est sans contact avec la deuxième surface de contact (S2).

4. Cellule mémoire selon l'une des revendications 1 à 2 **caractérisée en ce que** ladite zone locale est en contact avec la deuxième surface de contact (S2).

5. Cellule mémoire selon l'une des revendications précédentes **caractérisée en ce que** ladite zone locale présente un appauvrissement volumique en atomes de vanadium supérieur ou égal à 20% par rapport au reste de la couche active.

6. Cellule mémoire selon l'une des revendications précédentes **caractérisée en ce que** l'épaisseur de la couche active est comprise entre 5 et 200 nm et préférentiellement entre 10 et 100 nm.

7. Cellule mémoire résistive selon l'une des revendications précédentes **caractérisée en ce que** la zone locale présente une forme de dôme dont la section parallèle au plan des couches diminue depuis la première surface de contact.

8. Cellule mémoire selon l'une des revendications précédentes **caractérisée en ce que** l'électrode inférieure à base de nitrure de titane comporte du vanadium, du titane et de l'oxygène dans une zone localisée à proximité de la première surface de contact.

9. Cellule mémoire selon l'une des revendications précédentes **caractérisée en ce que** la première surface de contact présente une aire inférieure ou égale à 9000 nm² et préférentiellement inférieure ou égale à 6000 nm².

10. Cellule mémoire selon l'une des revendications précédentes **caractérisée en ce que** la première surface de contact est égale à la surface supérieure de l'électrode inférieure et est strictement inférieure à la surface totale inférieure de la couche active.

11. Cellule mémoire selon l'une des revendications précédentes **caractérisée en ce que** l'électrode inférieure présente une forme de parallélépipède rectangle de type « Wall » ou une forme en L.

12. Cellule mémoire selon l'une des revendications précédentes **caractérisée en ce que** l'oxyde de vanadium conducteur est cristallin ou partiellement cristallin.

13. Cellule mémoire selon l'une des revendications précédentes **caractérisée en ce que** la zone locale est dans un matériau cristallin ou partiellement cristallin.

14. Procédé de fabrication d'une cellule mémoire résistive selon l'une quelconque des revendications précédentes comportant les étapes suivantes :
- Réalisation d'une électrode inférieure à base de l'un des matériaux suivants : nitrure de titane TiN, nitrure de tantale TaN, tantale Ta, cuivre Cu, tungstène W, platine Pt, or Au ou argent Ag ;
- Dépôt d'une couche réalisée en oxyde de vanadium ayant une première surface de contact avec l'électrode inférieure ;
- Réalisation d'une électrode supérieure ;
**caractérisé en ce que** ledit procédé comporte une étape, dite étape d'initialisation, consistant à injecter un courant à travers un empilement formé par l'électrode inférieure, la couche d'oxyde de vanadium et l'électrode supérieure, la densité de courant étant choisie pour créer ladite zone locale comportant du vanadium, de l'oxygène et du Ti si le matériau de l'électrode inférieure est du TiN ou du Ta si le matériau de l'électrode inférieure est du TaN ou du Ta, ou du Cu si le matériau de l'électrode inférieure est du Cu, ou du W si le matériau de l'électrode inférieure est du W, ou du Pt si le matériau de l'électrode inférieure est du Pt, ou de l'Au si le matériau de l'électrode inférieure est de l'Au, ou de l'Ag si le matériau de l'électrode inférieure est de l'Ag.

15. Procédé selon la revendication précédente **caractérisé en ce qu'**il comporte une étape de traitement thermique pendant ou après ladite étape de dépôt jusqu'à rendre conducteur ladite couche en oxyde de vanadium.

16. Procédé de fabrication d'une cellule mémoire selon l'une des revendications 14 ou 15 **caractérisé en ce que** la densité de courant de l'étape d'initialisation est supérieure ou égale à 50.10⁶ A/cm².

17. Procédé de fabrication d'une cellule mémoire selon l'une des revendications 14 à 16 **caractérisé en ce que** le dépôt de la couche réalisée en oxyde de vanadium est réalisé par une technique de dépôt par faisceau d'ions.

## Patentansprüche

1. Resistive Speicherzelle (1) mit:
- einer unteren Elektrode (2) aus einem der folgenden Materialien: Titannitrid TiN, Tantalnitrid TaN, Tantal Ta, Kupfer Cu, Wolfram W, Platin Pt, Gold Au oder Silber Ag,
- einer oberen Elektrode (4),
- einer aktiven Schicht (3) mit einer ersten Kontaktfläche (S1) zur unteren Elektrode und einer zweiten Kontaktfläche (S2) zur oberen Elektrode,
**dadurch gekennzeichnet, dass** die aktive Schicht (3) einen sogenannten lokalen Bereich (5) aufweist, wobei der lokale Bereich aus einem Material besteht, das Vanadium, Sauerstoff und Ti enthält, wenn das Material der unteren Elektrode TiN ist, oder Ta, wenn das Material der unteren Elektrode TaN oder Ta ist, oder Cu, wenn das Material der unteren Elektrode Cu ist, oder W, wenn das Material der unteren Elektrode W ist, oder Pt, wenn das Material der unteren Elektrode Pt ist, oder Au, wenn das Material der unteren Elektrode Au ist, oder Ag, wenn das Material der unteren Elektrode Ag ist, wobei sich der lokale Bereich von der ersten Kontaktfläche (S1) aus erstreckt und der Rest der aktiven Schicht aus leitfähigem Vanadiumoxid besteht.

2. Speicherzelle nach dem vorstehenden Anspruch, **dadurch gekennzeichnet, dass** die obere Elektrode (4) auf Titannitrid basiert.

3. Speicherzelle nach einem der vorstehenden Ansprüche, **dadurch gekennzeichnet, dass** der lokale Bereich keinen Kontakt mit der zweiten Kontaktfläche (S2) hat.

4. Speicherzelle nach einem der Ansprüche 1 bis 2, **dadurch gekennzeichnet, dass** der lokale Bereich mit der zweiten Kontaktfläche (S2) in Kontakt steht.

5. Speicherzelle nach einem der vorstehenden Ansprüche, **dadurch gekennzeichnet, dass** der lokale Bereich einen Volumenmangel an Vanadiumatomen von mindestens 20 % gegenüber dem Rest der aktiven Schicht aufweist.

6. Speicherzelle nach einem der vorstehenden Ansprüche, **dadurch gekennzeichnet, dass** die Dicke der aktiven Schicht zwischen 5 und 200 nm und vorzugsweise zwischen 10 und 100 nm liegt.

7. Resistive Speicherzelle nach einem der vorstehenden Ansprüche, **dadurch gekennzeichnet, dass** der lokale Bereich eine Kuppelform aufweist, deren Querschnitt parallel zur Ebene der Schichten von der ersten Kontaktfläche aus abnimmt.

8. Speicherzelle nach einem der vorstehenden Ansprüche, **dadurch gekennzeichnet, dass** die untere Elektrode auf Titan-Nitrid-Basis in einem Bereich in der Nähe der ersten Kontaktfläche Vanadium, Titan und Sauerstoff enthält.

9. Speicherzelle nach einem der vorstehenden Ansprüche, **dadurch gekennzeichnet, dass** die erste Kontaktfläche eine Fläche von weniger als oder gleich 9000 nm² und vorzugsweise weniger als oder gleich 6000 nm² aufweist.

10. Speicherzelle nach einem der vorstehenden Ansprüche, **dadurch gekennzeichnet, dass** die erste Kontaktfläche gleich der oberen Fläche der unteren Elektrode ist und streng kleiner als die gesamte untere Fläche der aktiven Schicht ist.

11. Speicherzelle nach einem der vorstehenden Ansprüche, **dadurch gekennzeichnet, dass** die untere Elektrode eine rechteckige Parallelepipedform vom Typ "Wall" oder eine L-Form aufweist.

12. Speicherzelle nach einem der vorstehenden Ansprüche, **dadurch gekennzeichnet, dass** das leitfähige Vanadiumoxid kristallin oder teilweise kristallin ist.

13. Speicherzelle nach einem der vorstehenden Ansprüche, **dadurch gekennzeichnet, dass** der lokale Bereich in einem kristallinen oder teilweise kristallinen Material liegt.

14. Verfahren zur Herstellung einer resistiven Speicherzelle gemäß einem der vorstehenden Ansprüche, das die folgenden Schritte umfasst:
- Herstellen einer unteren Elektrode auf der Basis eines der folgenden Materialien: Titannitrid TiN, Tantalnitrid TaN, Tantal Ta, Kupfer Cu, Wolfram W, Platin Pt, Gold Au oder Silber Ag;
- Aufbringen einer Schicht aus Vanadiumoxid mit einer ersten Kontaktfläche zur unteren Elektrode;
- Herstellung einer oberen Elektrode;
**dadurch gekennzeichnet, dass** das Verfahren einen Schritt umfasst, der als Initialisierungsschritt bezeichnet wird und darin besteht, einen Strom durch einen Stapel zu leiten, der aus der unteren Elektrode, der Vanadiumoxidschicht und der oberen Elektrode gebildet wird, wobei die Stromdichte so gewählt wird, dass der lokale Bereich mit Vanadium, Sauerstoff und Ti entsteht, wenn das Material der unteren Elektrode TiN ist, oder Ta, wenn das Material der unteren Elektrode TaN oder Ta ist, oder Cu, wenn das Material der unteren Elektrode Cu ist, oder W, wenn das Material der unteren Elektrode W ist, oder Pt, wenn das Material der unteren Elektrode Pt ist, oder Au, wenn das Material der unteren Elektrode Au ist, oder Ag, wenn das Material der unteren Elektrode Ag ist.

15. Verfahren nach dem vorstehenden Anspruch, **dadurch gekennzeichnet, dass** es einen Schritt der Wärmebehandlung während oder nach dem Beschichtungsschritt umfasst, bis die Vanadiumoxidschicht leitfähig ist.

16. Verfahren zur Herstellung einer Speicherzelle gemäß einem der Ansprüche 14 oder 15, **dadurch gekennzeichnet, dass** die Stromdichte des Initialisierungsschritts größer oder gleich 50·10⁶ A/cm² ist.

17. Verfahren zur Herstellung einer Speicherzelle gemäß einem der Ansprüche 14 bis 16, **dadurch gekennzeichnet, dass** das Auftragen der aus Vanadiumoxid bestehenden Schicht mittels einer lonenstrahlauftragungstechnik erfolgt.

## Claims

1. A resistive memory cell (1) including:
- A lower electrode (2) based on one of the following materials: titanium nitride TiN, tantalum nitride TaN, tantalum Ta, copper Cu, tungsten W, platinum Pt, gold Au or silver Ag,
- An upper electrode (4),
- An active layer (3) having a first contact surface (S1) with the lower electrode and a second contact surface (S2) with the upper electrode,
**characterized in that** said active layer (3) includes a zone, referred to as the local zone (5), said local zone being made of a material including vanadium, oxygen and Ti if the material of the lower electrode is TiN or Ta if the material of the lower electrode is TaN or Ta, or Cu if the material of the lower electrode is Cu, or W if the material of the lower electrode is W, or Pt if the material of the lower electrode is Pt, or Au if the material of the lower electrode is Au, or Ag if the material of the lower electrode is Ag, said local zone extending from the first contact surface (S1), the rest of the active layer being made of conductive vanadium oxide.

2. The memory cell according to the preceding claim, **characterised in that** the upper electrode (4) is based on titanium nitride.

3. The memory cell according to one of the preceding claims, **characterised in that** said local zone is not in contact with the second contact surface (S2).

4. The memory cell according to one of claims 1 to 2, **characterised in that** said local zone is in contact with the second contact surface (S2).

5. The memory cell according to one of the preceding claims, **characterised in that** said local zone has a volume vanadium atom depletion greater than or equal to 20% relative to the rest of the active layer.

6. The memory cell according to one of the preceding claims, **characterised in that** the thickness of the active layer is between 5 and 200 nm and preferably between 10 and 100 nm.

7. The resistive memory cell according to one of the preceding claims, **characterised in that** the local zone has the shape of a dome whose cross-section parallel to the plane of the layers decreases from the first contact surface.

8. The memory cell according to one of the preceding claims, **characterised in that** the titanium nitride-based lower electrode includes vanadium, titanium and oxygen in a zone located in proximity to the first contact surface.

9. The memory cell according to one of the preceding claims, **characterised in that** the first contact surface has an area of less than or equal to 9000 nm² and preferably less than or equal to 6000 nm².

10. The memory cell according to one of the preceding claims, **characterised in that** the first contact surface is equal to the upper surface of the lower electrode and is strictly less than the total lower surface of the active layer.

11. The memory cell according to one of the preceding claims, **characterised in that** the lower electrode has a rectangular parallelepiped shape of the 'Wall' type or an L shape.

12. The memory cell according to one of the preceding claims, **characterised in that** the conductive vanadium oxide is crystalline or partially crystalline.

13. The memory cell according to one of the preceding claims, **characterised in that** the local zone is made of a crystalline or partially crystalline material.

14. A method for manufacturing a resistive memory cell according to any of the preceding claims, including the following steps of:
- Making a lower electrode based on one of the following materials: titanium nitride TiN, tantalum nitride TaN, tantalum Ta, copper Cu, tungsten W, platinum Pt, gold Au or silver Ag;
- Depositing a layer made of vanadium oxide having a first contact surface with the lower electrode;
- Making an upper electrode;
**characterized in that** said method includes a step, referred to as the initialisation step, consisting in injecting a current through a stack formed by the lower electrode, the vanadium oxide layer and the upper electrode, the current density being chosen to create said local zone including vanadium, oxygen and Ti if the material of the lower electrode is TiN or Ta if the material of the lower electrode is TaN or Ta, or Cu if the material of the lower electrode is Cu, or W if the material of the lower electrode is W, or Pt if the material of the lower electrode is Pt, or Au if the material of the lower electrode is Au, or Ag if the material of the lower electrode is Ag.

15. The method according to the preceding claim, **characterised in that** it includes a heat treatment step during or after said deposition step until said vanadium oxide layer is made conductive.

16. The method for manufacturing a memory cell according to one of the claims 14 or 15, **characterised in that** the current density of the initialisation step is greater than or equal to 50.10⁶ A/cm².

17. The method for manufacturing a memory cell according to one of the claims 14 to 16, **characterised in that** depositing the layer made of vanadium oxide is carried out by an ion beam deposition technique.
